Europäisches Patentamt

European Patent Office

Office européen des brevets

(19)

(11) Veröffentlichungsnummer: **0 339 307**
**A2**

# (12) EUROPÄISCHE PATENTANMELDUNG

(21) Anmeldenummer: **89105857.0**

(22) Anmeldetag: **04.04.89**

(51) Int. Cl.⁴: **G03C 1/68**

(30) Priorität: **29.04.88 DE 3814566**

(43) Veröffentlichungstag der Anmeldung:
**02.11.89 Patentblatt 89/44**

(84) Benannte Vertragsstaaten:
**FR GB IT**

(71) Anmelder: **DU PONT DE NEMOURS (DEUTSCHLAND) GMBH**
**Du Pont Strasse 1**
**D-6380 Bad Homburg(DE)**

(72) Erfinder: **Sondergeld, Manfred, Dr.**
**Biebererstrasse 46**
**D-6052 Mühlheim/Main(DE)**

(54) Verfahren zur Herstellung von Galvano- und Ätzmasken.

(57) Verfahren zur Herstellung von Galvano- und Ätzmasken umfassend Beschichten eines metallischen oder metallkaschierten Trägers mit einem lichtempfindlichen Gemisch, bildmäßiges Belichten der lichtempfindlichen Schicht und Auswaschen der unbelichteten Bereiche mit einem organischen Lösungsmittel oder -gemisch mit einem oder mehreren halogenierten Kohlenwasserstoffen als Hauptbestandteil, wobei das lichtempfindliche Gemisch mindestens ein carboxylgruppenhaltiges Polymer enthält.

EP 0 339 307 A2

EP 0 339 307 A2

## Verfahren zur Herstellung von Galvano- und Ätzmasken

Die Erfindung betrifft ein Verfahren zur Herstellung von Galvano- und Ätzmasken umfassend Beschichten eines metallischen oder metallkaschierten Trägers mit einem lichtempfindlichen Gemisch, mit mindestens einer additionspolymerisierbaren, ethylenisch ungesättigten Verbindung, einem Photoinitiator oder einem Photoinitiatorsystem und mindestens einem polymeren Bindemittel, das ein carboxylgruppenhaltiges Polymer ist, bildmäßiges Belichten der lichtempfindlichen Schicht und Auswaschen der unbelichteten Bereiche mit einem organischen Lösungsmittel oder -gemisch mit einem oder mehreren halogenierten Kohlenwasserstoffen als Hauptbestandteil.

Lichtempfindliche Gemische mit polymeren Bindemitteln, additionspolymerisierbaren Verbindungen, Photoinitiatoren und ggf. weiteren Zusatzstoffen, finden vielfach Verwendung in Bildaufzeichnungsmaterialien, insbesondere bei der Herstellung von Druckplatten, Lötstopmasken und Photoresists wie Galvano- und Ätzmasken.

Nach dem Stand der Technik können solche Aufzeichnungsmaterialien durch Spritzen, Gießen oder Drucken von flüssigen Gemischen auf ein Substrat oder auch durch Laminieren eines Trockenfilms auf ein Substrat hergestellt werden. Aus den US-Patentschriften US 3,469,982 und US 3,547,730 sind Filmresists mit einer Sandwichstruktur bekannt in Form einer photopolymerisierbaren Schicht zwischen einer Deckschicht und einem temporären Träger. Diese Filmresists können z.B. auf eine Kupferunterlage laminiert, bildmäßig belichtet und entwickelt werden, wodurch eine strukturierte Resistschicht gebildet wird. Diese Schicht erlaubt nun ein selektives Ätzen, Galvanisieren oder Löten auf dem Substrat.

Bedingt durch die ihnen zugrundeliegenden photopolymerisierbaren Gemische gibt es Photoresistmaterialien die mit organischen Lösungsmitteln entwickelbar sind, und solche, die wäßrig entwickelt werden.

Zu den letzteren gehören z.B. die in der DE-PS 25 56 845 beschriebenen Resistmaterialien auf der Basis von wasserlöslichen, ungesättigten Polyestern mit einer Säurezahl von 5 bis 100 und die in der DE-AS 25 17 656 beschriebenen mit einem Bindemittelgemisch aus zwei wasserunlöslichen, alkalilöslichen Bindemitteln mit einer Säurezahl von wenigstens 20 bzw. 5. Wäßrig entwickelbare Resistmaterialien sind auf Grund ihrer Zusammensetzung gegenüber Ätz- und Galvanobädern im Vergleich zu mit organischen Lösungsmitteln entwickelbaren Materialien relativ unbeständig.

Photoresistfilme, die mit halogenierten organischen Lösungsmitteln wie 1,1,1-Trichlorethan entwickelt werden, enthalten üblicherweise hydrophobe, polymere Bindemittel, die sich gegenüber den in der Ätz-und Galvanotechnik benutzten wäßrigen Verarbeitungsbädern inert verhalten. Dadurch wird eine zufriedenstellende Verarbeitungsbreite erzielt und ein Quellen, Ablösen und Untergalvanisieren der Resists vermieden.

Die Verwendung der genannten hydrophoben Bindemittel führt jedoch dazu, daß die damit hergestellten Photoresists in Galvanobädern mit hoher Oberflächenspannung, wie z.B. sauren Kupferbädern mit ~ 60 dyn/cm, an den Resistflanken nur unzureichend benetzt werden. Diese unzureichende Benetzung erlaubt keine gleichmäßige Metallabscheidung entlang der Resistflanke und führt somit zu einem unregelmäßigen Flankenaufbau. In den nachfolgenden Prozeßschritten werden dadurch Metalleiterzüge erhalten, deren Flanken Zacken und Ausätzungen enthalten. Die o.g., in organischen Lösungsmitteln löslichen Photoresistfilme führen daher bei ihrer Verwendung als Galvanoresists zu sogenannten gezackten Leiterbahnen. Da die Technik zu immer feineren Leiterbahnen fortschreitet, tritt dieses Problem verstärkt auf, und die bestehenden Resists können die an sie gestellten Anforderungen nicht mehr erfüllen.

Aufgabe der vorliegenden Erfindung ist es daher, mit halogenierten organischen Lösungsmitteln schnell und vollständig entwickelbare Photoresists zur Verfügung zu stellen, die bei der Verwendung als Galvanoresists Leiterbahnen mit gleichmäßigem Flankenaufbau liefern. Hierbei sollte das allgemeine Eigenschaftsprofil nicht negatiy beeinflußt werden. So sollte eine gute Lagerstabilität, große Verarbeitungs- und Anwendungsbreite und eine exakte Wiedergabe auch feiner Bildelemente gegeben sein. Gleichzeitig sollte die hohe Widerstandsfähigkeit der mit organischen Lösungsmitteln entwickelbaren Photoresists gegenüber Ätz- und Galvanobädern erhalten bleiben.

Diese Aufgabe wird gelöst durch ein Verfahren zur Herstellung von Galvano- und Ätzmasken umfassend Beschichten eines metallischen oder metallkaschierten Trägers mit einem lichtempfindlichen Gemisch mit mindestens einer additionspolymerisierbaren, ethylenisch ungesättigten Verbindung, einem Photoinitiator oder einem Photoinitiatorsystem und mindestens einem polymeren Bindemittel, das ein carboxylgruppenhaltiges Polymer ist, bildmäßiges Belichten der lichtempfindlichen Schicht und Auswaschen der unbelichteten Bereiche mit einem organischen Lösungsmittel oder -gemisch mit einem oder mehreren halogenierten Kohlenwasserstoffen als Hauptbestandteil.

Die Erfindung ist dadurch gekennzeichnet, daß das verwendete carboxylgruppenhaltige Polymer eine Säurezahl von 30 bis 70 mg KOH pro g Polymer besitzt.

2

Der erfindungsgemäße Einsatz von polymeren Bindemitteln, die einen bestimmten Carboxylgruppengehalt entsprechend einer Säurezahl von 30 bis 70 mg KOH pro g Polymer enthalten, in mit halogenierten Kohlenwasserstoffen entwickelbaren Photoresistmaterialien führt zu Galvanoresists, die durch eine bessere Benetzung der Resistflanke während des Kupfergalvanoprozesses zu einem gleichmäßigeren Kupferaufbau entlang der Resistflanke führen. In den folgenden Prozeßschritten wird dadurch ein gleichmäßiges Anätzen der Galvanolinie erzielt, so daß gedruckte Schaltungen mit gewünschtem Leitungsquerschnitt und Gleichmäßigkeit erhalten werden.

Gegen die Einführung von carboxylgruppenhaltigen Bindemitteln in mit halogenierten organischen Lösungsmitteln entwickelbare Photoresistmaterialien sprachen die nachteiligen Eigenschaften wäßrig entwickelbarer Photoresistmaterialien, die auch carboxylgruppenhaltige Polymere enthalten. Aus solchen wäßrig entwickelbaren Resistmaterialien hergestellte Ätz- und Galvanomasken zeigen nämlich eine geringe Beständigkeit gegenüber Ätz- und Galvanobädern. Sie lösen sich während der Behandlung vom Trägermetall ab und führen so zu Untergalvanisieren und undifferenziertem Ätzen der Metalloberfläche. Es war daher für den Fachmann nicht vorhersehbar, daß die Einführung carboxylgruppenhaltiger Polymere in mit halogenierten Kohlenwasserstoffen entwickelbare Resistmaterialien keine negativen Effekte auf die hervorragende Beständigkeit von mit solchen Resistmaterialien hergestellten Ätz- und Galvanomasken zeigt.

Ein weiteres Vorurteil war, daß mit den erfindungsgemäßen, carboxylgruppenhaltigen Polymeren keine rückstandsfreie Entwicklung der Resist-Materialien in halogenierten organischen Lösungsmitteln möglich sei. Der Fachmann hätte erwartet, daß derartig aufgebaute Photoresistfilme nur unvollständig und bestenfalls nur sehr langsam mit 1,1,1-Trichlorethan entwickelt werden können, so daß sie für eine Anwendung in der Praxis unbrauchbar sind. Wäßrig entwickelbare Photoresistfilme, deren Bindemittel Säurezahlen über 80 besitzen, können mit halogenierten Kohlenwasserstoffen nicht entwickelt werden. Überraschenderweise können die erfindungsgemäßen Resistmaterialien jedoch schnell und rückstandsfrei mit 1,1,1-Trichlorethan entwickelt werden.

In der EP 00 71 789 werden allgemein aminogruppenhaltige Bindemittel beschrieben, auch solche mit einem Gehalt an Carboxylfunktionen im Bereich von 0,01 bis 20 Gew.%. Für die Verwendung in mit 1,1,1-Trichlorethan entwickelbaren Resistmaterialien werden jedoch Polymere mit maximal 2 Gew.% Acrylsäure eingesetzt. Dieser Gehalt an Carboxylfunktionen ist jedoch eindeutig zu gering, um im Sinne der vorliegenden Erfindung einen positiven Effekt auf gezackte Leiterbahnen hervorzurufen. Erfindungsgemäß ist hierfür eine Säurezahl von mindestens 30 notwendig. Andererseits sollte die Säurezahl nicht über 70 liegen, da sonst keine einwandfreie Entwicklung mehr gewährleistet ist. Die in der EP 00 71 789 verwendeten Polymere enthalten zudem immer Amino gruppen, was den nachteiligen Effekt hat, daß Verfärbungen der Kupferoberfläche und außerdem Rückstände bei der Entwicklung auftreten können, bedingt durch die bessere Haftung, die die Aminogruppen hervorrufen.

In der EP 01 15 354 werden photopolymerisierbare Gemische für die Herstellung von Lötstopmasken beschrieben. Diese Gemische enthalten eine Kombination aus Melaminverbindungen und Polymeren mit einer Säurezahl ≥ 45 und einem pka-Wert ≥ 5, die nach der bildmäßigen Belichtung und der Entwicklung durch eine thermische Nachbehandlung bei 150° C vernetzt wird. Durch den Zusatz der Melaminverbindungen kann aber die Lichtempfindlichkeit der photopolymerisierbaren Gemische verringert werden, so daß solche Gemische längere Belichtungszeiten erfordern. Weiterhin neigen manche dieser Verbindungen bei längerer Lagerung der photopolymerisierbaren Massen zur Kristallisation, was zur Unbrauchbarkeit der Resistfilme führt. Zudem besteht die Gefahr, daß die Melaminverbindungen in den Galvanobädern ausgewaschen werden und die Metallabscheidung beeinträchtigen. Unter Berücksichtigung des Standes der Technik konnte der Fachmann nicht erwarten, daß durch den erfindungsgemäßen Einsatz von carboxylgruppenhaltigen Polymeren mit Säurezahlen von 30 bis 70 mg KOH/g Polymer in mit halogenierten organischen Lösungsmitteln entwickelbaren Photoresistmaterialien Galvano- und Ätzresists mit verbesserten chemischen und physikalischen Eigenschaften hergestellt werden können.

Die erfindungswesentlichen, carboxylgruppenhaltigen Polymere besitzen eine Säurezahl zwischen 30 und 70 mg KOH/g Polymer, bevorzugt zwischen 45 und 60 mg KOH/g Polymer. Der Anteil dieser Polymere am gesamten Bindemittel kann bis zu 100 % betragen. Ihr Anteil an der gesamten Photoresisttrockenmasse muß mindestens 20 Gew.% betragen. Folgende Bindemittel können z.B. in Kombination mit dem erfindungswesentlichen Polymer eingesetzt werden: Polymere und/oder Copolymere von Acrylaten, Methacrylaten, Acrylamiden, Methacrylamiden und/oder substituierten und/oder unsubstituierten Styrolen, bevorzugt werden: Copolymere von Alkylacrylaten und/oder -methacrylaten mit Styrol.

Bei den erfindungswesentlichen, carboxylgruppenhaltigen Bindemitteln handelt es sich um Copolymere olefinisch ungesättigter Carbonsäuren mit anderen Monomeren. Bevorzugt werden Copolymere aus Acrylsäure, Methacrylsäure, Maleinsäure und Itaconsäure mit Styrol und/oder Alkylacrylaten und/oder -methacrylaten verwendet. Außerdem können auch die Reaktionsprodukte von Copolymerisaten olefinisch

3

ungesättigter Carbonsäure- und/oder Dicarbonsäureanhydride mit den o.g. Comonomeren und Wasser, Alkoholen und/oder Aminen eingesetzt werden, bevorzugt werden hierbei: Maleinsäure-, Itaconsäure- und Citraconsäureanhydride.

Geeignete additionspolymerisierbare, ethylenisch ungesättigte Verbindungen, die allein oder in Kombination mit anderen Monomeren verwendet werden können, umfassen Acrylsäure- und Methacrylsäurederivate wie (Meth)acrylamide, Alkylacrylate, Alkylmethacrylate und besonders Ester der Acrylsäure und Methacrylsäure mit Diolen und Polyolen wie Ethylenglykol, Diethylenglykol, Trimethylolpropan, Pentaerythrit, Polyethylenglykole.

Die Gesamtmenge an Monomeren in dem lichtempfindlichen Gemisch beträgt 10 bis 80 Gew.% bezogen auf die gesamten Bestandteile des Gemischs. Als Photoinitiatoren oder Photoinitiatorsystem in dem erfindungsgemäßen lichtempfindlichen Gemisch können praktisch alle für diesen Zweck bekannten Verbindungen verwendet werden, als Beispiele seien genannt: 9-Phenylacridin, 9,10-Dimethylbenz(a)phenazin, Benzophenon/Michlers Keton, Hexaarylbisimidazol/Mercaptobenzoxazol. Die Photoinitiatoren werden allgemein in einer Menge von 0,01 bis 10 Gew.% verwendet.

Das lichtempfindliche Gemisch kann noch weitere Zusätze wie z.B. Farbstoffe, Pigmente, Weichmacher, Haftvermittler, Füllstoffe und/oder Stabilisatoren enthalten.

Das Aufbringen des lichtempfindlichen Gemischs auf den metallischen oder metallkaschierten Träger erfolgt beispielsweise durch Sprühen, Tauchen oder Gießen aus einer Lösung oder durch Laminieren eines Trockenfilms. Die Schichtdicke beträgt gewöhnlich 5 bis 200 $\mu$m. Bevorzugt werden Schichtübertragungsmeterialien verwendet. Hierzu wird das lichtempfind liche Gemisch auf einen temporären Schichtträger, vorzugsweise eine Polyesterfolie, aufgebracht und als Deckfolie eine entfernbare Kunststoffolie auflaminiert. Zur Herstellung des Resistbildes wird dann die Deckfolie abgezogen, und die lichtempfindliche Schicht auf einen metallischen oder metallkaschierten Träger, meist eine Kupferoberfläche, auflaminiert. Das Material wird dann bildmäßig belichtet und entwickelt, wobei der temporäre Schichtträger vor oder nach der Belichtung entfernt werden kann. Die Entwicklung erfolgt durch Auswaschen der nicht polymerisierten Bildteile mit organischen Lösungsmitteln bzw. -gemischen mit einem oder mehreren halogenierten Kohlenwasserstoffen als Hauptbestandteil. Anschließend kann die so hergestellte Resistschicht in üblicher Weise, unter Benutzung der bekannten Galvanisier- oder Ätzmethoden, weiterbehandelt werden, ohne daß der Resist abgelöst wird, Untergalvanisieren auftritt oder gezackte Leiterbahnen beobachtet werden.

Obwohl die Erfindung in der vorstehenden Beschreibung bevorzugt in ihrer Anwendung als Schichtübertragungsmaterial für Photoresists beschrieben wurde, ist sie nicht auf diese Anwendung beschränkt. Sie ist in allen Fällen anwendbar, in denen es darauf ankommt, bildmäßige Schablonen bzw. Reliefmaterialien von besonders hoher chemischer und physikalischer Beständigkeit zu erzeugen.

Die nachfolgenden Beispiele sollen die Erfindung erläutern.

Beispiel 1

Es wurde folgende Gießlösung hergestellt:

| 44 ml | Methylenchlorid |
|---|---|
| 6,7 ml | Methanol |
| 3,5 g | eines Copolymeren aus Methylmethacrylat/Methacrylsäure SZ = 56, MG = 30 000 |
| 7 g | eines Copolymeren aus Methylmethacrylat/Ethylacrylat/Acrylsäure SZ = 60, MG = 150 000 |
| 8,4 g | eines Copolymeren aus Methylmethacrylat/Ethylmethylacrylat (75/25), MG = 100 000 |
| 11,9 g | polyoxyethyliertes Trimethylolpropantriacrylat |
| 2,1 g | Polyethylenglykol-400-diacrylat |
| 0,87 g | Benzildimethylketal |
| 0,24 g | Chlor-Thioxanthon |
| 0,87 g | Dimethylaminobenzoesäureethylester |
| 53 mg | Nilblau (C.I. 51180) |

Die Gießlösung wurde auf eine 25 $\mu$m dicke Polyesterunterlage aufgebracht, so daß eine Trockenschichtdicke von 40 $\mu$m erreicht wurde. Der Trockenresistfilm wurde mit einem handelsüblichen Laminator bei 110° C Walzentemperatur mit einer Geschwindigkeit von 1,5 m/min auf mit 35 $\mu$m Kupfer kaschiertes Basismaterial aufgebracht.

Der Resist wurde durch eine Galvanovorlage mit Linien und Zwischenräumen von 75 $\mu$m bis 300 $\mu$m mit 60

4

mj/cm² belichtet und in einem RISTON* C-Processor mit 1,1,1-Trichlorethan bei Raumtemperatur mit einer Geschwindigkeit von 2,0 m/min entwickelt. Es wurde ein einwandfrei ausgewaschenes Resistmuster erhalten.

Die erhaltene Platte wurde unter üblichen Bedingungen vorgereinigt und angeätzt. Es wurde in einem handelsüblichen Kupferbad mit einer Stromstärke von 2,5 A/dm² während 36 min 20 μm Kupfer und in einem handelsüblichen Blei/Zinn-Bad mit einer Stromstärke von 2,0 A/dm² während 10 min 10 μm Blei/Zinn aufgalvanisiert.

Der Resist wurde in einer handelsüblichen Strippmaschine mit Methylenchlorid sauber und rückstandsfrei entschichtet, das Basiskupfer in einer Ätzmaschine bei 50° C weggeätzt. Nach dem Ablösen des Blei/Zinn Ätzresistes wurden Kupferleiterzüge bis herunter zu 75 μm Linienbreite mit einwandfreier Kantendefinition ohne jegliche Ausätzungen oder Zacken erhalten.

Beispiel 2

Es wurde folgende Gießlösung hergestellt:

| | |
|---|---|
| 44 ml | Methylenchlorid |
| 6,7 ml | Methanol |
| 21,0 g | eines Copolymeren aus Methylmethacrlat/Styrol/Maleinsäureanhydrid SZ = 115, MG = 30 000 |
| 1,24 g | Isopropylamin |

Diese Lösung wurde 1 h gerührt, um das Maleinsäureanhydrid quantitativ in das Monoamid zu überführen, so daß eine Säurezahl von 57,5 erreicht wurde.

Anschließend wurde weiter zugegeben:

| | |
|---|---|
| 10,09 g | polyoxyethyliertes Trimethylolpropantriacrylat |
| 2,1 g | Polypropylenglykol-420-diacrylat |
| 1,4 g | Benzophenon |
| 0,05 g | Ethyl Michler's Keton |
| 40 mg | Nilblau (C.I. 51180) |

Die Gießlösung wurde wie in Beispiel 1 auf eine Polyesterunterlage aufgebracht.

Der Trockenresistfilm wurde wie in Beispiel 1 weiterverarbeitet. Es wurden 30 μm Kupfer und 10 μm Blei/Zinn aufgalvanisiert.

Nach dem Strippen des Resist, Wegätzen des Basiskupfers und Ablösen des Blei/Zinns wurden Kupferleiterzüge mit einwandfreier Kantendefinition ohne Ausätzungen oder Zacken erhalten.

Vergleichsbeispiel 1

Es wurde folgende Gießlösung hergestellt:

| | |
|---|---|
| 50 ml | Methylenchlorid |
| 18,9 g | eines Copolymeren aus Methylmethacrylat/Ethylmethacrylat (75/25), MG = 100 000 |
| 11,2 g | polyoxyethyliertes Trimethylolpropantriacrylat |
| 1,4 g | Benzophenon |
| 0,05 g | Ethyl Michler's Keton |
| 53 mg | Nilblau (C.I. 51180) |

Die Gießlösung wurde wie in Beispiel 1 auf eine Polyesterunterlage aufgebracht.

Der Trockenresistfilm wurde wie in Beispiel 1 weiterverarbeitet. Es wurden 20 μm Kupfer und 10 μm Blei/Zinn aufgalvanisiert.

Nach dem Strippen des Resist, Wegätzen des Basiskupfers und Ablösen des Blei/Zinns wurden Kupferleiterzüge erhalten, deren Kanten unregelmäßige Ausätzungen oder nach außen ragende Zacken enthielten.

Die Qualität von Leiterzügen unter 150 μm Linienbreite war für praktische Anwendungen absolut unbrauchbar.

Vergleichsbeispiel 2

Es wurde folgende Gießlösung hergestellt:

| 44 ml | Methylenchlorid |
|---|---|
| 6,7 ml | Methanol |
| 18,55 g | eines Copolymeren aus Styrol/Ethylacrylat/Acrylsäure/Methylmethacrylat (40/20/15/25) SZ = 115, Mw = 50 000 |
| 4,9 g | pyrogene Kieselsäure |
| 4,2 g | Polycaprolactonmonoacrylat |
| 3,1 g | Tripropylenglykoldiacrylat |
| 3,1 g | Reaktionsprodukt aus Bisphenol-A-diglycidylether und Acrylsäure |
| 0,67 g | Dimethylaminobenzoesäureethylester |
| 0,3 g | Isopropylthioxanthon |
| 45 mg | Victoria Grün (C.I. 42000) |

Die Gießlösung wurde wie in Beispiel 1 auf eine Polyesterunterlage aufgebracht. Der Trockenresistfilm wurde wie in Beispiel 1 auf Kupfer kaschiertes Basismaterial aufgebracht, belichtet und mit 1,1,1-Trichlorethan entwickelt. Nach der Entwicklung wurde in den ausgewaschenen Bereichen deutliche Rückstandsbildung beobachtet, so daß die Platte nicht zum Galvanisieren benutzt werden konnte.

**Ansprüche**

1. Verfahren zur Herstellung von Galvano- und Ätzmasken umfassend
a) Beschichten eines metallischen oder metallkaschierten Trägers mit einem lichtempfindlichen Gemisch mit
1. mindestens einer additionspolymerisierbaren, ethylenisch ungesättigten Verbindung,
2. einem Photoinitiator oder einem Photoinitiatorsystem und
3. mindestens einem polymeren Bindemittel, das ein carboxylgruppenhaltiges Polymer ist,
b) bildmäßiges Belichten der lichtempfindlichen Schicht, und
c) Auswaschen der unbelichteten Bereiche mit einem organischen Lösungsmittel oder -gemisch mit einem oder mehreren halogenierten Kohlenwasserstoffen als Hauptbestandteil, dadurch gekennzeichnet, daß
das verwendete carboxylgruppenhaltige Polymer eine Säurezahl von 30 bis 70 mg KOH pro g Polymer besitzt.

2. Verfahren zur Herstellung von Galvano- und Ätzmasken nach Anspruch 1 dadurch gekennzeichnet, daß
das carboxylgruppenhaltige Polymer mindestens 20 Gew.% der Photoresisttrockenmasse ausmacht.
3. Verfahren zur Herstellung von Galvano- und Ätzmasken nach Anspruch 1 und 2 dadurch gekennzeichnet, daß
das carboxylgruppenhaltige Polymer das alleinige Bindemittel ist.
4. Verfahren zur Herstellung von Galvano- und Ätzmasken nach Anspruch 1 bis 3 dadurch gekennzeichnet, daß
das carboxylgruppenhaltige Polymer ein Copolymerisat olefinisch ungesättigter Carbonsäuren mit anderen Monomeren ist.

5. Verfahren zur Herstellung von Galvano- und Ätzmasken nach Anspruch 1 bis 3
dadurch gekennzeichnet, daß
das carboxylgruppenhaltige Polymer das Reaktionsprodukt eines Copolymerisates aus olefinisch ungesättigten Carbonsäure- und/oder Dicarbonsäureanhydriden und anderen Monomeren mit Wasser, Alkoholen und/oder Aminen ist.

6. Verfahren zur Herstellung von Galvano- und Ätzmasken nach Anspruch 4 und 5
dadurch gekennzeichnet, daß
als andere Monomere Styrol, Isopren, Butadien, (Meth)acrylamide, (Meth)acrylnitril und/oder (Meth)acrylate verwendet werden.

7. Verfahren zur Herstellung von Galvano- und Ätzmasken nach Anspruch 1 bis 6
dadurch gekennzeichnet, daß
als halogenierte Kohlenwasserstoffe 1,1,1-Trichlorethan und/oder Perchlorethylen verwendet werden.

8. Verfahren zur Herstellung von Galvano- und Ätzmasken nach Anspruch 1 bis 7
dadurch gekennzeichnet, daß
die lichtempfindliche Schicht mit einer Kunststoffolie versehen ist, die vor oder nach dem bildmäßigen Belichten entfernt wird.